# EUROPEAN PATENT APPLICATION

(11) **EP 4 488 758 A1**
(43) Date of publication of application: **08.01.2025**
(21) Application number: 23183500.0
(22) Date of filing: 05.07.2023
(51) Int. Cl.: G03F 7/20, H01L 21/687, G02B 5/08, G02B 26/08

(54) **OBJECT HOLDER WITH A SUPPORT SURFACE HAVING A PLURALITY OF SUPPORT ELEMENTS OR OPTICAL ELEMENT FOR A LITHOGRAPHIC APPARATUS, COMPRISING A METAL-SI MULTILAYER, A METAL-GE MULTILAYER AND/OR A CHROMIUM NITRIDE LAYER CONFIGURED TO PROVIDE A SELECTIVELY CHANGEABLE HEIGHT OF INDIVIDUAL SUPPORT ELEMENTS OR SHAPE OF THE OPTICAL ELEMENT VIA THERMAL TREATMENT AND METHOD OF CORRECTING FLATNESS OF A SURFACE OF THE OBJECT HOLDER OR THE OPTICAL ELEMENT**

(71) Applicant: ASML Netherlands B.V., 5500 AH Veldhoven (NL)
(72) Inventor: ALLSOP, Nicholas, Alan, 5500 AH Veldhoven (NL); WIGGERS, Frank, Bert, 5500 AH Veldhoven (NL)
(74) Representative: ASML Netherlands B.V.

(57) **Abstract**

There is provided an object holder configured to support an object, comprising a support surface having a plurality of support elements that comprise a metal-Si multilayer, metal-Ge multilayer, and/or a chromium nitride layer to provide a selectively changeable height of individual support elements via thermal treatment of the metal-Si multilayer, metal-Ge multilayer, and/or chromium nitride layer. Also provided is an object table comprising such an object holder, an apparatus for controlling the flatness of a surface comprising such an object holder, an optical element for a lithographic apparatus, an apparatus for controlling the flatness of a surface, a lithographic apparatus or tool comprising such an object holder, a method of controlling the shape of a surface, a method of manufacturing an object holder, a method of correcting the flatness of an object holder or optical element, and the use of such apparatuses or method in a lithographic apparatus or process.

## Description

### FIELD

The present disclosure relates to an object holder, an object table, an optical element, and a lithographic apparatus or tool comprising such an object holder, optical element, or object table. The present disclosure also relates to a method of controlling the flatness of a surface. Also described is the use of such an object holder, object table, lithographic apparatus or methods in a lithographic method or apparatus. The object holder may be part of an object table of a lithographic apparatus or lithographic tool. The present disclosure has particular, but not exclusive, application to EUV and DUV lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate to be exposed may be supported by a substrate holder (i.e. the object that directly supports a substrate), which in turn is supported by a substrate table. The substrate holder may have an array of projections or support elements, referred to as burls, projecting from at least one side. When the substrate rests on the top of the burls on the at least one side of the substrate holder, the substrate may be spaced apart from a main body of the substrate holder. This may aid in the prevention of a particle (i.e. a contaminating particle such as a dust particle), which may be present on the substrate holder, from distorting the substrate holder or substrate. The total surface area of the burls may only be a small fraction of the total area of the substrate or substrate holder. As such, it is more probable that any particle will lie between burls and its presence will have no effect. The tops of the burls define a plane on which objects lie when engaged therewith.

Due to the high accelerations that may be experienced by the substrate in use of a high-throughput lithographic apparatus, it may not be sufficient to allow the substrate simply to rest on the burls of the substrate holder. It is clamped in place. Two methods of clamping the substrate in place may be used - vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate table and/or substrate holder. The potential difference may generate a clamping force.

It is important to control the flatness of the substrate, which may be, for example, a wafer. Whilst a substrate may have a flatness which in within specification when it is not in situ within a lithographic apparatus, the flatness may change when the substrate is held in position within a lithographic apparatus due to the forces acting upon it, such as those from electrostatic or vacuum clamping. In this way, the so-called functional flatness of the substrate, namely the flatness when in position for use, needs to be controlled as although the free substrate may be within specification, an in-situ substrate may not. Similarly, it is desirable to provide optical elements, such as mirrors, with optimised surface shapes to achieve optimal results and accuracy.

In use, surfaces are subject to wear and tear as well as contamination, and the flatness of surfaces can be negatively affected. The surfaces may be subject to uneven wear and tear, which limits performance and limits the lifetime of the component. Replacement of the components subject to wear also results in significant downtime of the associated apparatus, thereby reducing throughput.

The present disclosure has been devised in an attempt to address at least some of the problems identified above.

### SUMMARY

According to a first aspect of the invention there is provided an object holder configured to support an object, the object holder comprising a support surface having a plurality of support elements, wherein the plurality of support elements comprise a metal-Si multilayer, a metal-Ge multilayer, and/or a chromium nitride layer configured to provide a selectively changeable height of individual support elements via thermal treatment of the metal-Si multilayer, metal-Ge multilayer, and/or chromium nitride layer. The metal may be selected from titanium, molybdenum, or any combination thereof.

The flatness of object holders, such as wafer tables and wafer clamps, is adjusted by one of two methods. Firstly, ion-beam figuring (IBF) adjusts the flatness by etching the surface of the object holder by ion bombardment in an offline setup. By offline setup, it will be understood that this is outside of a lithographic apparatus used for imaging wafers. It is possible to correct the heights of individual burls, and the ability to do this is determined by the spot size of the ion beam. It is not possible to undertake IBF within a lithographic scanner as it requires an ion source and the removal of the material would cause contaminant materials to spread within the scanner and cause contamination issues. In operation, the flatness may drift due to a variety of reasons including wear, indentation, and contamination. The flatness provides a strong contribution to On Product Overlay (OPO) and the need to replace clamps, which involves long downtimes, is driven by flatness degradation. Similarly, with optical elements, such as mirrors or mirror block, flatness correction takes place using IBF, after which the mirror coating is applied and the surface flatness can no longer be corrected. Laser ablation can be used to remove material from a target, but this has a minimum height removal of around 40 to 60 nm per pulse, which limits it suitability since the difference in height of support element which causes focus problems and lost dies is less than this. As such, laser ablation would remove too much material and could also generate unwanted contaminants.

The present disclosure addresses the shortcomings of existing techniques, by providing a material which can be heated to alter the height of individual support elements. Although it will be appreciated that materials contract and expand upon temperature change, this does not allow for the stable change in height of support elements, such as burls, whereas the use of materials which undergo a phase transition allows such changes in height to be stable. By stable it is understood that the phases does not change at the operating temperatures experienced in nominal use and over the timescale over which the object holder is in nominal use. In this way, the present disclosure allows for individual support elements, such a burls, to be adjusted. Since the height of the burls are adjusted without the removal of material, the adjustment may be effected within a scanner. This is further advantageous since the functional flatness of a substrate can differ between scanners, and it is not possible to correct for this external to the scanner. The present disclosure allows for the support surface to be made flat or unflat in order to correct for differences between individual scanners and ultimately provide a functional flatness that corrects for overlay and/or focus errors of other parts of the system, for example to correct for non-ideal focus plane and bring a specific wafer into focus. When a Ti-Si multilayer is heated, the formation of TiSi and/or TiSi₂ resulting in a dimensional change. A similar effect is seen for metal-germanium multilayers. Similarly, it has been found that a chromium nitride layer may be densified, and therefore reduce in volume, by selective heating. Such a reduction in volume can be utilised to adjust the height of a support element. The formula of the Ti-Si multilayer may be TiSiₓ wherein 0.3 ≤ x ≤ 2. The Ti-Si multilayer may comprise any number of alternating layers of Ti and Si. Similarly, for a Mo-Si multilayer, this may comprise any number of alternating layers of Mo and Si. Similarly, for a metal-Ge multilayer, any number of alternating layers of Ge and metal may be used. The formula of the metal-Ge multilayer may be MGeₓ wherein 0.3 ≤ x ≤ 2. It will be appreciated that the multilayer may include different metals, which may be in the same layer, and/or in different layers. The thickness of each individual layer in the multilayer may be from around 2 nm to around 100 nm, and are preferably from around 10 to around 20nm, in thickness. The layers may be provided by sputtering, optionally magnetron sputtering. It will be appreciated that not all of the support elements necessarily comprise the multilayer. Preferably, the support elements which are subject to most wear in operation are provided with the multilayer.

For example, burls which have an increase height of 12 nm or more, which may be caused by indentations or contamination issues, are sufficient to cause focus problems and lost dies. At the edge of the support surface, the support elements are subject to wear and can be worn down in use by from around 20 to 50 nm, which limits performance. Both of these effects limits the lifetime of the support surface and can lead to premature replacement and associated downtime. By being able to correct the height of the supporting elements, the desired shape of the support surface can be adjusted and the lifetime of the support surface can thereby be extended.

The plurality of support elements may be burls. It will be appreciated that not all of the support elements or burls need to include the metal-Si multilayer, metal-Ge multilayer, and/or chromium nitride layer. In embodiments, all of the support elements include a metal-Si multilayer, a metal-Ge multilayer, and/or chromium nitride layer. In other embodiments, only some of the support elements include a metal-Si multilayer, metal-Ge multilayer, and/or chromium nitride layer. Preferably, in embodiments in which only some of the support elements include a metal-Si multilayer, a metal-Ge multilayer, and/or chromium nitride layer, the metal-Si multilayer, metal-Ge multilayer, and/or chromium nitride layer is provided to the support elements which are subject to the greatest wear and tear.

The object holder may be a substrate holder. The object holder may be a wafer holder, such as a wafer table or wafer clamp, such as an electrostatic wafer clamp. The object holder may be a reticle holder, such as a reticle clamp or reticle table. Indeed the substrate holder may be any holder which requires micrometer or nanometer accuracy in flatness.

The plurality of support elements may comprise a top coating layer. It will be appreciated that the material comprising the top coating layer may be, but is preferably, different to the metal-Si multilayer and/or metal-Ge multilayer and/or chromium nitride layer, such as the Ti-Si multilayer material, the Mo-Si multilayer material, the Ti-Ge multilayer material, Mo-Ge multilayer, chromium nitride layer, or combinations of any thereof. The top coating layer material may be any known top layer material. The top coating material may be selected from chromium nitride, diamond-like carbon, or a combination thereof. It will be appreciated that where the top coating comprises chromium nitride, that the heat treatment may be applied to portions of the top coating in order to densify the materials and thereby adjust the shape of the surface of the top surface.

The thickness of the metal-Si multilayer, metal-Ge multilayer, and/or chromium nitride layer may be up to around 1400 nm, up to around 1300 nm, up to around 1200 nm, up to around 1100 nm, up to around 1000 nm, up to around 900 nm, up to around 800 nm, up to around 700nm, up to around 600 nm, up to around 500 nm, up to around 400 nm, up to around 300 nm, up to around 200 nm or up to around 100 nm. The thickness of the metal-Si multilayer, metal-Ge multilayer, or chromium nitride layer can be selected to provide the desired range of height adjustment required for a given application.

According to a second aspect of the present disclosure, there is provided an object table comprising an object holder according to the first aspect.

According to a third aspect of the present disclosure, there is provided optical element for a lithographic apparatus, the optical element comprising a metal-Si multilayer, metal-Ge multilayer, or chromium nitride layer configured to selectively change in shape via thermal treatment of the metal-Si multilayer, metal-Ge multilayer, and or chromium nitride layer. As with the first aspect, the metal of the metal-Si multilayer and/or metal-Ge multilayer may be selected from titanium, molybdenum, or any combination thereof. The optical element may be a mirror or a mirror block.

It was not previously possible to correct deformation in the surface of a mirror after IBF correction and application of the mirror layer. Such deformations may arise in the mirror layer itself and from the assembly process. The present disclosure allows for deformations to be corrected by selective heating of the metal-Si multilayer, metal-Ge multilayer, and/or chromium nitride layer even after the mirror surface has been provided.

According to a fourth aspect of the present disclosure, there is provided an apparatus for controlling the flatness of a surface, the apparatus comprising the object holder or optical element according to the present disclosure and a means for changing a phase configuration of the metal-Si multilayer, metal-Ge multilayer, and or chromium nitride layer.

It will be appreciated that controlling the flatness does not necessarily mean making the surface as flat as possible, since it may be necessary to correct for errors in other parts of a system to which the apparatus is applied by providing an un-flat surface such that when a substrate is engaged with the surface, the substrate is deformed into a desired shape.

The means for changing the phase configuration may be any kind of heater, such as an electric heater or a laser. A laser may be preferred due to its high accuracy.

According to a fifth aspect of the present disclosure, there is provided a lithographic apparatus or tool comprising an object holder according to the first aspect, an object table according to the second aspect, an optical element according to the third aspect, or an apparatus according to the fourth aspect of the present disclosure.

According to a sixth aspect of the present disclosure, there is provided a method of correcting the flatness of a surface of an object holder or optical element of a lithographic apparatus, the method comprising: providing a surface comprising at least one material capable of volume change upon heating and controlling the flatness of the surface via thermal treatment of the at least one material capable of volume change upon heating, optionally wherein the at least one material capable of volume change upon heating is a multilayer, optionally a chromium nitride multilayer or a metal-Si multilayer, or a metal-Ge multilayer, optionally wherein the metal is selected from titanium, molybdenum, or any combination thereof.

As described above, it is possible to correct the shape of a surface by providing a surface with a phase change material, namely a metal-Si multilayer and/or a chromium nitride layer and/or a metal-Ge multilayer, that allows for the control of the height of areas of the surface. Previously, this was not possible to do in situ.

Correcting the flatness of the surface may be achieved by selectively heating the material to a predetermined temperature and annealing, optionally by laser heating.

Controlling the flatness of the surface preferably takes place within a lithographic apparatus.

It was previously not possible to adjust the shape of a surface within a lithographic apparatus due to the risk of particle contamination. The present disclosure overcomes this shortcoming by allowing for *in situ* adjustment of the shape of a surface by way of selectively heating a metal-Si multilayer, a metal-Ge multilayer, and/or a chromium nitride layer.

According to a seventh aspect of the present disclosure, there is provided the use of an object holder according to the first aspect, an object table according to the second aspect, an optical element according to the third aspect, an apparatus according to the fourth aspect, a lithographic apparatus or tool according to the fifth aspect, or a method according to the sixth aspect of the present disclosure in a lithographic method or apparatus..

Various aspects and features of the invention set out above or below may be combined with various other aspects and features of the invention as will be readily apparent to the skilled person. All such combinations are explicitly considered and disclosed herein.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 is a schematic depiction of a cross-section of a surface according to the present disclosure;
- Figure 3 is a schematic depiction of an optical element 18 according to the present disclosure;
- Figures 4a to 4c depict White Light Interferometry (WLI) images showing the change in height of a chromium nitride stack and associated data; and
- Figures 5a and 5b depict comparative atomic force microscopy (AFM) images of a chromium nitride surface out of the annealing spot (5a) and in the annealing spot (5b).

### DETAILED DESCRIPTION

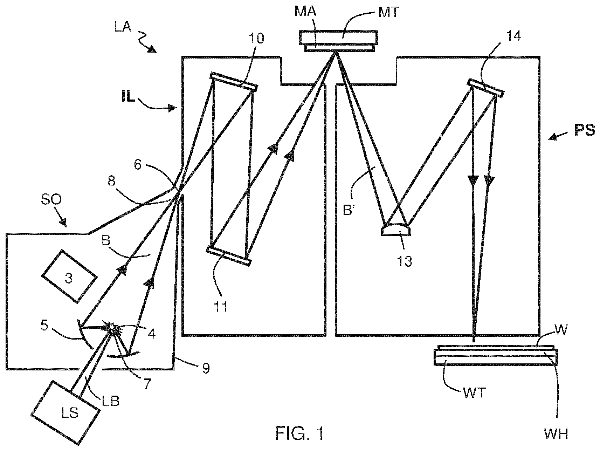

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and an object table WT. The object table WT may comprise an object holder WH configured to support an object W. The object W may be provided in the form of a substrate. The object table WT may be provided in the form of a substrate table. The object holder WH may be provided in the form of a substrate clamp. The substrate may be a wafer.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1
is, for example, of a type which may be referred to as a laser produced plasma (LPP) source. A laser system LS, which may, for example, include a CO₂ laser, is arranged to deposit energy via a laser beam LB into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam LB is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure, which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system LS may be spatially separated from the radiation source SO. Where this is the case, the laser beam LB may be passed from the laser system LS to the radiation source SO with the aid of a beam delivery system (not shown) comprising, for example, suitable directing mirrors and/or a beam expander, and/or other optics. The laser system LS, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

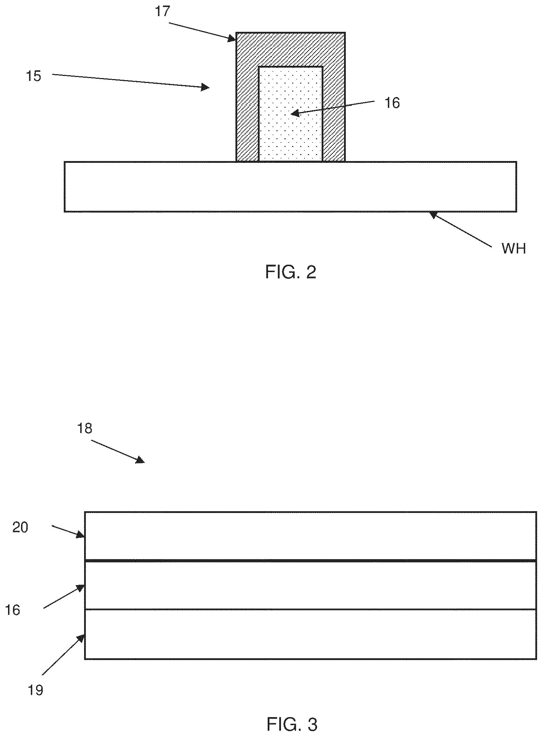

Figure 2 is a schematic depiction of a cross-section of a surface according to the present disclosure. A single burl 15 is depicted, although it will be appreciated that there will be a plurality of burls provided on a surface. The burl 15 comprises a metal-Si multilayer, such as Ti-Si multilayer or a Mo-Si multilayer 16, which is capped by a capping material 17 such as chromium nitride and/or diamond like carbon. A metal-Ge multilayer may alternatively or additionally be provided. It will be appreciated that reference to a metal-Si multilayer equally applies to a metal-Ge multilayer and/or chromium nitride layer. Whilst it is depicted that the capping material 17 surrounds the metal-Si multilayer 16, it will be appreciated that the capping material 17 may be provided on only the top of the metal-Si multilayer 16.

In use, individual burls 15 are controlled in height by the selective heating and annealing of the metal-Si multilayer 16 forming at least part of the burls 15. Any suitable heating method may be used, but lasers are preferred due to their accuracy and precision. A pulsed laser may be used. The heat source may be focused on a single burl or a group of burls. The degree of heating and rate of cooling can be controlled by adjusting the intensity and duration of laser pulses. By adjusting the intensity and duration of laser pulses, it is possible to provide the desired surface shape by adjusting the heights of the burls 15. The change in height of the burls is stable in the normal operating temperature range of the substrate holder WH, which may be from 0°C to 100°C such that a change of phase and physical properties is only enacted by the intended heat source.

Figure 3 is a schematic depiction of an optical element 18 according to the present disclosure. The optical element comprises a base layer 19 which supports a metal-Si multilayer 16. In embodiments, there may be a chromium nitride layer and/or a metal-Ge multilayer in addition to or instead of the metal-Si multilayer. The metal-Si multilayer supports a mirror layer 20 which is configured to reflect incident light. The provision of the metal-Si multilayer 16, which can be adjusted by selective heating, allows the overlying mirror layer 20 to be adjusted as required. Without the metal-Si multilayer 16, there is no way of changing the shape of the mirror layer 20 within a lithographic apparatus since other techniques generate contaminants and/or are not viable to do within a lithographic apparatus.

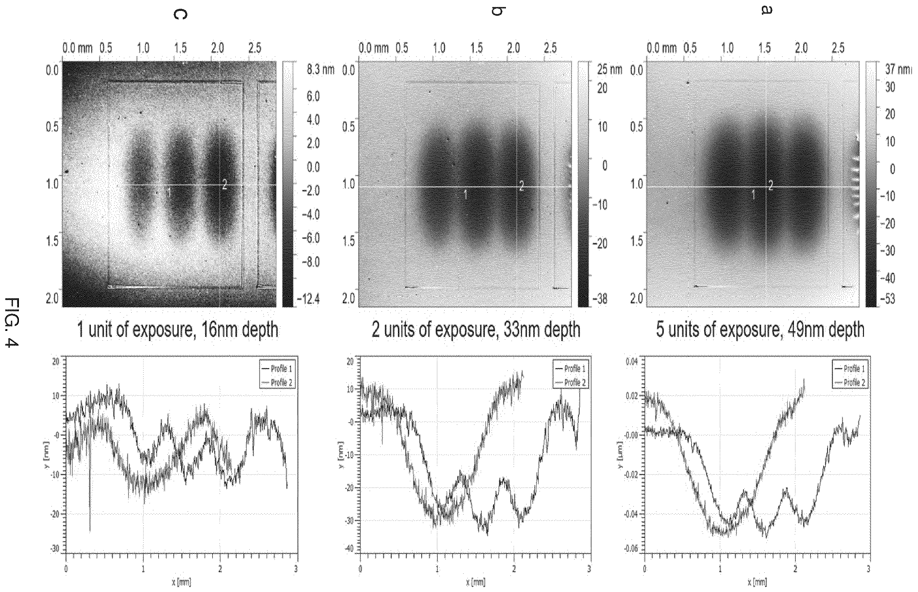

Figures 4a to 4c depict White Light Interferometry (WLI) images showing the change in height of a chromium nitride stack. Each of the images demonstrates how the surface of a chromium nitride stack comprising a standard density chromium nitride layer on top of a porous layer of chromium nitride, on top of an already densified layer of chromium nitride on a layer of glass can be locally exposed to infra red laser light at several positions to different amounts of heat load and show corresponding lowering of the surface height. The associated graphs show a cross section along a horizontal axis 1 and a vertical axis 2. In each of the graphs, the three areas of lower height can be seen via corresponding dips in the line on the graph. Similarly, the single dip moving through a vertical axis corresponds to the single reduction in height along this axis. As can be seen, the degree of height change is dependent on the exposure, with additional units of exposure causing a greater change in height.

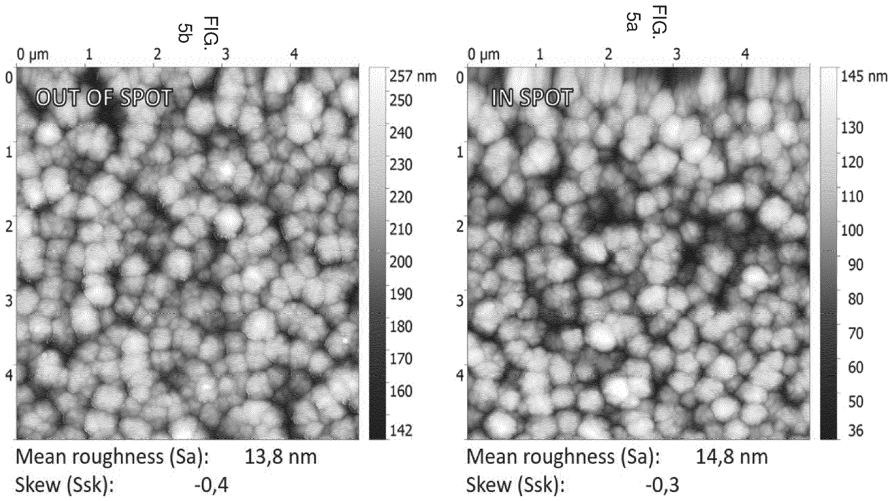

Figures 5a and 5b depict comparative atomic force microscopy (AFM) images of a chromium nitride surface out of the annealing spot (5a) and in the annealing spot (5b). As can be seen, the exposure to annealing via selective heating does not affect the surface morphology and roughness and the differences in mean roughness and skew being within natural variability of the surface.

It will be appreciated that optical elements for use in lithography apparatus may already include a chromium nitride layer. It has not previously been recognised that it is possible to adjust the shape of the surface of an optical element by densifying chromium nitride. As such, the method according to the present invention can be used to recondition existing optical elements when this was previously not thought to be possible without using processes which are less sensitive and which also have the potential to generate unwanted particulates. Since no particulates are generated by the methods described herein, they are suitable for use *in situ,* which has previously not been possible. Furthermore, where the heat source is a laser, the laser can also be used to clean surfaces which are contaminated with particles and/or organic contaminants.

The present disclosure can be used to control the shape of the surface of electrostatic wafer clamps, reticle clamps, vacuum wafer chucks and mirror blocks, amongst others.

It will be understood that references to a plurality of features may be interchangeably used with references to singular forms of those features, such as for example "at least one" and/or "each". Singular forms of a feature, such as for example "at least one" or "each," may be used interchangeably.

Although embodiments of the invention have been described in connection with a substrate, a substrate holder and a substrate table, in other embodiments the invention may be used to clamp a mask MA (or other patterning device) to a support structure MT of a lithographic apparatus (see Figure 1), or to clamp some other object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions. An object holder according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Aspects of the present disclosure are described in the following numbered clauses:
1. An object holder configured to support an object, the object holder comprising a support surface having a plurality of support elements, wherein the plurality of support elements comprise a metal-Si multilayer, a metal-Ge multilayer, and/or a chromium nitride layer configured to provide a selectively changeable height of individual support elements via thermal treatment of the metal-Si multilayer, metal-Ge multilayer, and/or chromium nitride layer.
2. An object holder according to clause 1, wherein the metal is selected from molybdenum, titanium, or any combination thereof.
3. The object holder according to clause 1 or clause 2, wherein the plurality of support elements are burls.
4. The object holder according to any preceding clause, wherein the object holder is a wafer clamp, preferably an electrostatic wafer clamp, a wafer table, a reticle table, or a reticle clamp.
5. The object holder of any preceding clause, wherein the plurality of support elements comprise a top coating material, optionally wherein the top coating material is selected from chromium nitride, diamond-like carbon, or a combination thereof.
6. The object holder of any preceding clause, wherein the thickness of the metal-Si multilayer, metal-Ge multilayer, and/or chromium nitride layer is up to around 1400 nm, up to around 1300 nm, up to around 1200 nm, up to around 1100 nm, up to around 1000 nm, up to around 900 nm, up to around 800 nm, up to around 700nm, up to around 600 nm, up to around 500 nm, up to around 400 nm, up to around 300 nm, up to around 200 nm or up to around 100 nm.
7. The object holder of any preceding clause, wherein the thickness of the layers in the multilayer range from around 2 nm to around 100 nm, optionally from around 10 nm to around 20 nm.
8. An object table comprising an object holder according to any preceding clause.
9. An optical element for a lithographic apparatus, the optical element comprising a metal-Si multilayer, a metal-Ge multilayer, or a chromium nitride layer configured to selectively change in shape via thermal treatment of the metal-Si multilayer, metal-Ge multilayer, and/or chromium nitride layer, optionally wherein the metal is selected from titanium, molybdenum, or any combination thereof, optionally wherein the optical element is a mirror or a mirror block.
10. An apparatus for controlling the flatness of a surface, the apparatus comprising the object holder or optical element according to any preceding clause and a means for changing a phase configuration of the metal-Si multilayer, metal-Ge multilayer, and/or chromium nitride layer, optionally wherein the means comprises a laser and/or an electrical heater.
11. A lithographic apparatus or tool comprising the object holder of any of clauses 1 to 7, the object table of clause 8, the optical element of clause 9, or the apparatus of clause 10.
12. A method of correcting the flatness of a surface of an object holder or optical element of a lithographic apparatus, the method comprising: providing a surface comprising a metal-Si multilayer, a metal-Ge multilayer, and/or a chromium nitride layer and controlling the flatness of the surface via thermal treatment of the metal-Si multilayer, metal-Ge multilayer, and/or chromium nitride layer, optionally wherein the metal is selected from titanium, molybdenum, or any combination thereof.
13. The method according to clause 12, wherein correcting the flatness of the surface is achieved by selectively heating the material to a predetermined temperature and annealing, optionally by laser heating.
14. The method according to any of clauses 12 and 13, wherein controlling the flatness of the surface takes place within a lithographic apparatus.
15. The use of an object holder according to any of clauses 1 to 7, an object table according to clause 8, an optical element for a lithographic apparatus according to clause 9, an apparatus according to clause 10, a lithographic apparatus or tool according to clause 11, or a method according to any of clauses 12 to 14 in a lithographic method or apparatus.

## Claims

1. An object holder configured to support an object, the object holder comprising a support surface having a plurality of support elements, wherein the plurality of support elements comprise a metal-Si multilayer, and/or a metal-Ge multilayer, and/or a chromium nitride layer configured to provide a selectively changeable height of individual support elements via thermal treatment of the metal-Si multilayer, metal-Ge multilayer, and/or chromium nitride layer.

2. An object holder according to claim 1, wherein the metal is selected from molybdenum or titanium, or any combination thereof.

3. The object holder according to claim 1 or claim 2, wherein the plurality of support elements are burls.

4. The object holder according to any preceding claim, wherein the object holder is a wafer clamp, preferably an electrostatic wafer clamp, a wafer table, a reticle table, or a reticle clamp.

5. The object holder of any preceding claim, wherein the plurality of support elements comprise a top coating material, optionally wherein the top coating material is selected from chromium nitride, diamond-like carbon, or a combination thereof.

6. The object holder of any preceding claim, wherein the thickness of the metal-Si multilayer, metal-Ge multilayer, and/or chromium nitride layer is up to around 1400 nm, up to around 1300 nm, up to around 1200 nm, up to around 1100 nm, up to around 1000 nm, up to around 900 nm, up to around 800 nm, up to around 700nm, up to around 600 nm, up to around 500 nm, up to around 400 nm, up to around 300 nm, up to around 200 nm or up to around 100 nm.

7. The object holder of any preceding claim, wherein the thickness of the layers in the multilayer or layer range from around 2 nm to around 100 nm, optionally from around 10 nm to around 20 nm.

8. An object table comprising an object holder according to any preceding claim.

9. An optical element for a lithographic apparatus, the optical element comprising a metal-Si multilayer and/or metal-Ge multilayer and/or chromium nitride layer configured to selectively change in shape via thermal treatment of the metal-Si multilayer, metal-Ge multilayer, and/or chromium nitride layer, optionally wherein the metal is selected from titanium, molybdenum, or any combination thereof, optionally wherein the optical element is a mirror or a mirror block.

10. An apparatus for controlling the flatness of a surface, the apparatus comprising the object holder or optical element according to any preceding claim and a means for changing a phase configuration of the metal-Si multilayer, metal-Ge multilayer, and/or chromium nitride layer, optionally wherein the means comprises a laser and/or an electrical heater.

11. A lithographic apparatus or tool comprising the object holder of any of claims 1 to 7, the object table of claim 8, the optical element of claim 9, or the apparatus of claim 10.

12. A method of correcting the flatness of a surface of an object holder or optical element of a lithographic apparatus, the method comprising: providing a surface comprising at least one material capable of volume change upon heating and controlling the flatness of the surface via thermal treatment of the at least one material capable of volume change upon heating, optionally wherein the at least one material capable of volume change upon heating is a multilayer, optionally a chromium nitride multilayer or a metal-Si multilayer or a metal-Ge multilayer, optionally wherein the metal is selected from titanium, molybdenum,, or any combination thereof.

13. The method according to claim 12, wherein correcting the flatness of the surface is achieved by selectively heating the at least one material to a predetermined temperature and annealing, optionally by laser heating.

14. The method according to any of claims 12 and 13, wherein controlling the flatness of the surface takes place within a lithographic apparatus.

15. The use of an object holder according to any of claim 1 to 7, an object table according to claim 8, an optical element for a lithographic apparatus according to claim 9, an apparatus according to claim 10, a lithographic apparatus or tool according to claim 11, or a method according to any of claims 12 to 14 in a lithographic method or apparatus.
